# EUROPEAN PATENT SPECIFICATION

(11) **EP 0 321 763 B1**
(45) Date of publication and mention of the grant of the patent: **01.05.1996**
(21) Application number: 88120242.8
(22) Date of filing: 05.12.1988
(51) Int. Cl.: H01L 23/52, H01L 23/528, H01L 21/74, H01L 21/82

(54) **Complementary metal oxide silicon (CMOS) device structure**
Anordnung von CMOS-Typ
Dispositif du type CMOS

(30) Priority: 21.12.1987 US 135954
(43) Date of publication of application: 28.06.1989
(73) Proprietor: International Business Machines Corporation, Armonk, N.Y. 10504 (US)
(72) Inventor: Kenney, Donald McAlpine, Shelburne Vermont 05 482 (US)
(74) Representative: Schäfer, Wolfgang, Dipl.-Ing.

(56) References cited:
- EP-A- 0 284 065
- US-A- 4 463 491
- US-A- 4 498 223
- US-A- 4 593 459
- IBM TECHNICAL DISCLOSURE BULLETIN, vol. 29, no. 3, August 1986, pp. 1037-1038, Armonk, New York, US ; "CMOS process for titanium salicide bridging of a trench and simultaneously allowing for true gate isolation"

## Description

The invention relates to a complementary metal oxide silicon (CMOS) device structure having a novel type of interconnection between differently doped regions.

Reference is made to co-pending EP application 0 264 692 assigned to the assignee of the present invention. The application relates to forming a bridge contact between a polysilicon-filled trench storage capacitor and an adjacent diffusion region.

In complementary metal oxide silicon (CMOS) technology, the gate electrodes of n-channel and p-channel field effect transistors (FET) are interconnected. Thus, for a given applied voltage, one of the two devices will always be off. Such an arrangement provides a great power savings as compared to NMOS (i.e., solely n-channel FET) technology, wherein unnecessary current paths to ground abound.

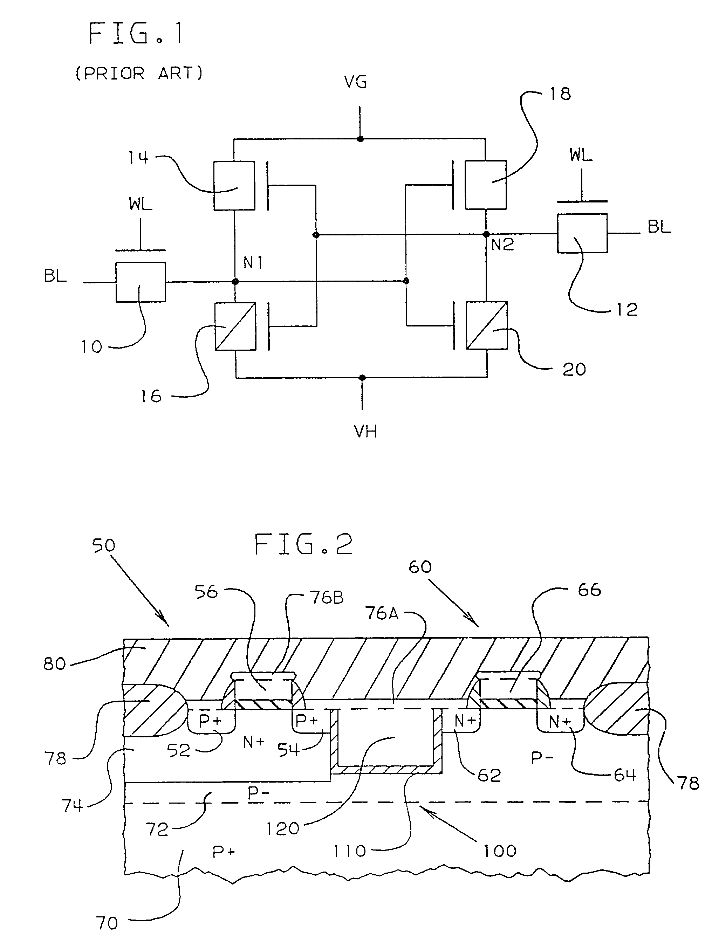

In some CMOS circuits, it is also necessary to interconnect one of the n-type source/drain diffusion regions to one of the p-type source/drain diffusion regions. An example of such a circuit is the conventional six device static random access memory (SRAM) cell shown in Fig. 1 (Prior Art). In Fig. 1, the p-channel transistors are indicated by the boxes having a line through them and the n-channel transistors are indicated by the empty boxes. N-channel transistors 10 and 12 serve to access the memory cell defined by the four device latch comprised of n-channel devices 14 and 18 and p-channel devices 16 and 20. Of interest is the interconnection at N1 between the n-channel drain diffusion of transistor 14 and the p-channel drain diffusion of transistor 16, as well as the interconnection at N2 between the n-type drain diffusion of transistor 18 and the p-type drain diffusion of transistor 20.

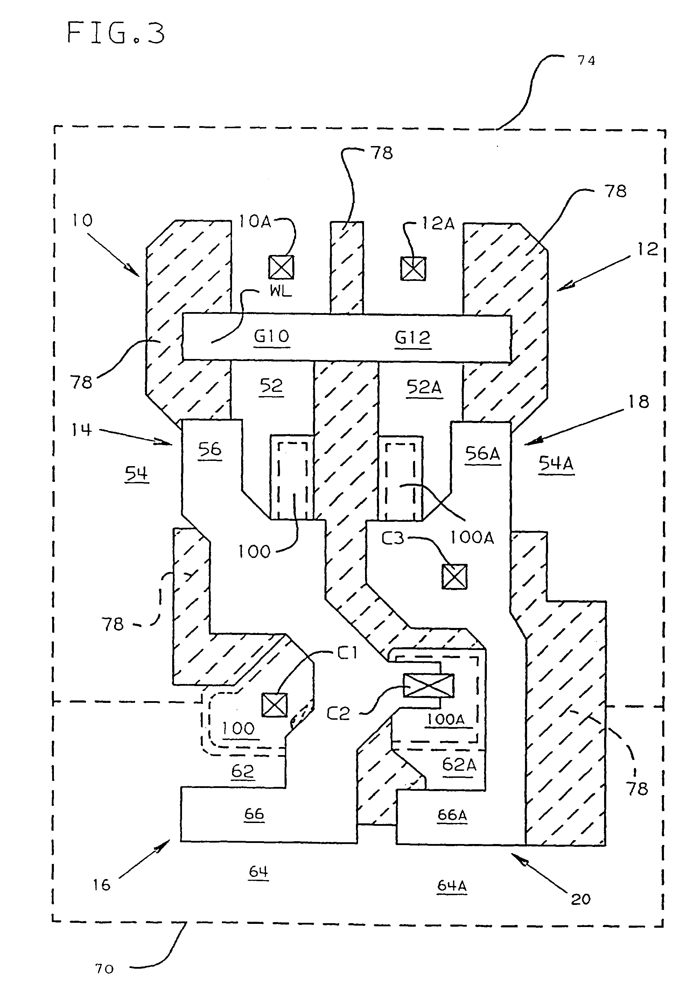

Conventionally, these diffusion interconnections would be accomplished by depositing a layer of metal coupled to the diffusion regions in question through vias formed in a passivation layer. Examples of such interconnections are shown in Figs. 1 and 2 of U.S. Patent 4,661,202, entitled "Method of Manufacturing Semiconductor Device," issued April 28, 1987, to Ochii and assigned to Toshiba. This patent also shows a trench filled with dielectric material for isolating the n-channel and p-channel devices from one another.

However, this conventional interconnect method presents disadvantages when applied to a circuit such as the SRAM cell of Fig. 1. Here, the circuit must be designed to maximize density. If we use the prior art metal interconnect techniques, the metal layer must provide (a) the interconnect between the diffusion regions at nodes N1 and N2; (b) the interconnect between node N1 and the gates of devices 18 and 20; (c) the interconnect between node N2 and the gates of devices 14 and 16, (d) the metal bit lines; and (e) the supply voltage contacts for VH and VG. It has been found by layout modelling that a metal layer cannot be defined to simultaneously meet all of the above interconnect requirements without substantially degrading the density of the memory cell.

In considering which of these interconnect functions should be borne by another conductive structure, it would be advantageous to use a structure that is on the same topological level as the structures to be interconnected. For example, the CMOS gate electrodes are typically interconnected by the same polysilicon layer that defines the gates. Since the interconnect functions (b)-(e) above necessitate an interconnection between a structure at one topological level to a structure of another topological level, it would be advantageous to meet interconnect requirement (a) utilizing a conductive structure at the same topological level (i.e., beneath the substrate surface) as the diffusion regions. The diffusion regions must be interconnected in a manner that does not affect the latchup prevention normally provided by an intervening isolation structure (see e.g., the Ochii patent cited above). If the diffusion regions are interconnected by simply incorporating a doped silicon region, unacceptable source/drain to substrate or n-well connections result.

Thus, a need has developed in the art for a structure that interconnects n-type diffusion regions and p-type diffusion regions without degrading circuit performance.

It is thus an object of the present invention to provide a means for interconnecting n-type diffusions and p-type diffusions using a conductive structure at the same topological level as the diffusions.

It is another object of the invention to provide a sub-surface diffusion interconnection means that does not degrade the performance characteristics of the resulting circuit.

It is yet another object of the invention to provide a diffusion interconnect means that maximizes the layout density of a CMOS circuit.

These and other objects of the invention are realized by structures as disclosed in claims 1 and 5.

In more detail the inventive structure provides a sub-surface interconnection means for interconnecting an n-type diffusion to a p-type diffusion. The interconnection means is comprised of a conductor-filled trench disposed between the diffusion regions. The trench has a thin dielectric layer on its sidewalls and bottom. The conductor within the trench contacts the diffusion regions. Parasitic device formation between the diffusion regions is suppressed because the trench provides a parasitic gate that is shorted to the parasitic source regions (i.e., the interconnected diffusion regions). As such, the trench may be more shallow than conventional trench isolation structures. Moreover, the trench provides an enlarged contact area to the interconnected diffusion regions for the subsequently-applied metal layer.

Advantageous embodyments of the inventive structure are disclosed in the subclaims.

The above and other structures and teachings of the present invention will become more apparent from the following detailed description. In the description to follow, reference will be made to the accompanying drawings, in which:
- Fig. 1: (Prior Art) is a schematic diagram of a conventional six-device SRAM cell;
- Fig. 2: is a cross-sectional view of a substrate showing the interconnection structure of the invention; and
- Fig. 3: is a top view of a six-device SRAM cell layout utilizing the interconnection structure of the invention.

Fig. 2 shows a substrate 70 having a p-channel device 50 and an n-channel device 60 formed thereon. The substrate 70 is <100> oriented, P+ type monocrystalline silicon. A P- type epitaxial silicon layer 72 is grown on the substrate 70, and an N well 74 is defined in a portion of the epitaxial layer 72 by conventional masking and implantation steps. Although a single N well CMOS substrate is shown, the invention could also be practiced on a "twin-tub" (i.e., separate N and P wells) CMOS substrate or a P well CMOS substrate. The p-channel device 50 is formed in the N well 74, and comprises P+ type source/drain diffusion regions 52, 54 and a gate electrode 56 disposed over a portion of the substrate between the diffusion regions 52, 54 so as to control the channel region of the device. Similarly, n-channel transistor 60 comprises N+ type source/drain diffusion regions 62, 64, and a gate electrode 66 that controls the channel region of the device. The gate electrodes 56, 66 of the two transistors are formed from the same conductor material (e.g., doped polysilicon, a refractory metal such as tungsten, a refractory metal silicide such as tungsten silicide, etc.) disposed on respective gate dielectrics. The conductor is continuous between the two electrodes, to thus provide electrical interconnection therebetween. A passivating layer 80 (e.g., a doped glass such as borophosphosilicate glass or phosphosilicate glass, or an organic resin such as polyimide) is coated on the substrate, and a layer of metal (not shown) is deposited on the passivation layer to provide contact through vias (not shown) etched through the passivation layer.

Of particular interest is the filled trench 100 disposed between the P+ diffusion region 54 and the N+ diffusion region 62. A conductive layer 120 disposed within the trench electrically interconnects the diffusion regions 54 and 62 to one another. The conductor 120 (which may be comprised of any of the conductive materials listed above, preferably of P type doped polysilicon) is insulated from the substrate 70 by a thin dielectric structure 110.

Conductive regions provide electrical interconnection between the diffusion regions and the poly-filled trench. These conductive regions could be formed by depositing and etching a conductive layer on the surface of the substrate, or by depositing a layer of refractory metal (such as titanium) under conditions promoting columnar grain growth, and sintering to form titanium silicide (as disclosed in the above-mentioned co-pending EP application 0 264 692). However, it is preferred to form the conductive regions by exposing the substrate to conditions (SiCl₂H₂ plus HCl at 880°C and 53.32 mbar) under which epitaxial silicon selectively grows only on the exposed silicon regions and extends laterally to cover the thin dielectric 110 without covering the other dielectric regions, depositing a refractory metal such as titanium (at 390°C), and sintering to form a silicide that bridges over the dielectric 110 to form a bridge contact 76A while enhancing the conductivity of the gate, source and drain electrodes by providing silicide regions 76B thereon.

The trench has a dielectric structure much thinner than normally used for isolation 110 disposed on its sidewalls. The dielectric structure can be made of silicon oxide, silicon nitride, silicon oxynitride, or combinations thereof. In general, the dielectric is on the order of up to 20 nm in thickness. This is generally much thinner than the dielectric layers normally used to provide isolation. The reasons for this will be explained below. A bilayer structure of silicon oxide (4 nm) and silicon nitride (7 nm) has been found to provide sufficient dielectric properties.

A conductor-filled trench has been used in dynamic random access memory (DRAM) applications, wherein the conductor is electrically interconnected to a diffusion region of the access transistor to provide a storage capacitor structure. See Lu et al, "The SPT Cell - A New Substrate-Plate Trench Cell For DRAMS," ISSCC Digest of Technical Papers 1987. Moreover, trenches filled with undoped polysilicon having thick dielectric layers (up to 500 nm) disposed on their sidewalls are known for providing isolation between adjacent n-channel and p-channel devices. See U.S. Patent 4,647,957, entitled "Latchup-Preventing CMOS Device," issued 3/3/87 to Loquin et al and assigned to AT&T.

As described above, the filled trench of the invention provides a sub-surface interconnection between differentiallydoped diffusion regions. This eliminates the need to interconnect the diffusions by using a layer of metal, thus increasing the density of the resulting integrated circuits.

The filled trench provides enhanced isolation between the n-channel and p-channel transistors. The thin dielectric described above permits the conductive trench fill 120 to act as a control gate for parasitic devices that may form between the n-channel and p-channel devices. For example, the trench fill 120 gates the parasitic device defined by P+ type diffusion 54, N well 74, and the P+ type substrate. Because the trench fill 120 is electrically interconnected to source diffusion region 54, and because the P+ substrate is always the parasitic drain at ground potential, the gate-to-source differential is always zero, such that the parasitic FET device will never turn on. Similarly, a second parasitic defined by N well 74, epi 72, and N+ type diffusion region 62 is gated by the conductive fill 120 interconnected to diffusion region 62, such that its gate-to-source is zero and because the N-well is always the parasitic drain at +Vh potential, and it cannot turn on. In other words, the filled trench provides a gate-to-source interconnection that prohibits parasitic formation about its sidewalls. In practice, the depth of the trench is not critical. It can be as deep as the diffusion, or it can extend to the bottom of the n-well to provide an additional p-n boundary.

Fig. 3 shows a top view of a layout for a six-device SRAM cell as shown schematically in Fig. 1, using the sub-surface trench connection of the invention. In Fig. 3, reference numerals repeated from Figs. 1-2 indicate the same structural features. Thus, the gates of transistors 10 and 12 of Fig. 1 are defined by the polysilicon portions G10, G12 of polysilicon line WL, the drain regions thereof are defined by the portion of the substrate 70 contacted by BL contacts 10A and 12A, and the source regions thereof are defined by the portion of the substrate below the polysilicon line WL. These latter substrate portions also define diffused electrodes 52, 52A of p-type devices 14 and 18. The gate electrodes of devices 14 and 18 are defined by polysilicon portions 56, 56A, respectively. The other diffused electrodes of devices 14 and 18 are defined by substrate portions 54, 54A on the other side of polysilicon portions 56, 56A, respectively. Finally, devices 16 and 20 are defined by diffusion regions 62, 62A, and 64, 64A, with intervening polysilicon portions 66, 66A providing the gate electrodes, respectively. Isolation is provided by regions 78.

The gates 56, 66 and 56A, 66A of transistors 14, 16, and 18, 20, respectively, are provided by the same polysilicon line and thus are interconnected. The polysilicon line defining the gates of transistors 14, 16 is interconnected to the diffused electrode 62A of device 20 by a contact C₂ which is covered by a metal segment (not shown). The polysilicon line defining the gates of transistors 18, 20 is interconnected to the diffusion regions 62 of transistor 16 by a metal line (not shown) that couples the contacts C₁ and C₃ together. Other metal lines and contacts (not shown) provide the ground and VH contacts. Of particular interest are the poly-filled trenches 100, 100A that interconnect nodes N1 and N2 (i.e., diffused electrodes 52, 52A of transistors 14, 18) to diffused electrodes 62, 62A of devices 16, 20, respectively. If this interconnection was provided by the overlaying metal layer, the layout would have to be expanded to accommodate contacts for regions 52 and 52A. Moreover, additional space would be required to provide interconnection metal lines that would not interfere with the C₂-C₃ interconnection.

The layout shown in Fig. 3 illustrates another advantage of the invention. Normally, in forming a metal contact, the alignment to the underlying diffused electrode is critical. For example, in forming contact C₁, a critical alignment would normally be maintained with respect to the edge of the N+ well 74 as well as to the adjacent polysilicon lines and isolation regions. However, because of the poly-filled trench 100 coupled to region 62, alignment to these structures is no longer critical because the trench presents an enlarged area to contact. As shown in Fig. 3, the contact C₁ can now be formed beyond the edge of the N well 74. By minimizing these critical alignment constraints, the possibility of misalignment decreases, to thus increase the manufacturing yield of wafers processed to provide the structures of the invention.

## Claims

1. A sub-surface structure in a semiconductor circuit formed in a substrate of a first conductivity type having a well region therein of a second conductivity type for interconnecting a first diffusion region of a second conductivity type formed in the substrate to a second diffusion region of said first conductivity type formed within said well region, whereby said structure is located at the same topological level as said diffusions comprising a trench having sidewalls and a bottom, said trench being filled with a conductive material and having a thin dielectric structure disposed on said sidewalls and bottom thereof, whereby said filled trench is disposed between and adjacent to the first diffusion region of the second conductivity type and the second diffusion region of the first conductivity type, said conductive material disposed within said trench being electrically connected to both of said first and second diffusion regions.

2. The structure as recited in claim 1, wherein said conductive material is selected from the group consisting of doped polysilicon, refractory metals, refractory metal silicides, and combinations thereof.

3. The structure as recited in claim 1 or 2, wherein said dielectric structure comprises a material selected from the group consisting of silicon oxide, silicon nitride, and silicon oxynitride.

4. The structure as recited in any one of claims 1 to 3, wherein said dielectric structure comprises a first layer of silicon oxide formed on said sidewalls and bottom of said trench, and a second layer of silicon nitride atop said first layer of silicon oxide.

5. A sub-surface structure in an integrated circuit comprising at least one p-channel device and at least one n-channel device formed in a substrate, each of said devices having source and drain diffused electrodes for interconnecting one of the source and drain electrodes of said p-channel device to one of the source and drain electrodes bf said n-channel device, comprising a doped polysilicon-filled trench having sidewalls and a bottom, covered by a thin dielectric structure, said trench being formed between said p-channel and n-channel devices and adjacent said one of the source and drain electrodes of said p-channel device and said one of the source and drain electrodes of said n-channel device, said trench being located at the same topological level as the source and drain diffused electrodes.

## Patentansprüche

1. Struktur unter der Oberfläche in einer Halbleiterschaltung, die in einem Substrat eines ersten Leitfähigkeitstyps ausgebildet ist, das einen darin ausgebildeten vertieften Bereich eines zweiten Leitfähigkeitstyps zur Verbindung eines ersten Diffusionsgebietes eines zweiten Leitfähigkeitstyps, das in dem Substrat ausgebildet ist, mit einem zweiten Diffusionsgebiet des Leitfähigkeitstyps, das in dem vertieften Bereich ausgebildet ist, besitzt, wobei sich die Struktur in der gleichen topologischen Ebene wie die Diffusionsgebiete befindet, die einen Graben umfassen, der Seitenwände und einen Boden besitzt, wobei der Graben mit einem leitfähigen Material gefüllt ist und eine dünne dielektrische Struktur an dessen Seitenwänden und Boden angeordnet ist, wobei der gefüllte Graben zwischen und angrenzend an das erste Diffusionsfebiet des zweiten Leitfähigkeitstyps und das zweite Diffusionsgebiet des ersten Leitfähigkeitstyps angeordnet ist, wobei das leitfähige Material, das innerhalb des Grabens angeordnet ist, elektrisch sowohl mit dem ersten als auch mit dem zweiten Diffusionsgebiet verbunden ist.

2. Struktur nach Anspruch 1, wobei das leitfähige Material aus der Gruppe, die aus dotiertem Polysilicium, hochschmelzenden Metallen, hochschmelzenden Metallsiliciden und Kombinationen daraus besteht, ausgewählt wird.

3. Struktur nach Anspruch 1 oder 2, wobei die dielektrische Struktur ein Material beinhaltet, das aus der Gruppe, die aus Siliciumoxid, Siliciumnitrid und Siliciumoxynitrid besteht, ausgewählt wird.

4. Struktur nach irgendeinem der Ansprüche 1 bis 3, wobei die dielektrische Struktur eine erste Schicht aus Siliciumoxid, die an den Seitenwänden und auf dem Boden des Grabens ausgebildet wurde, und eine zweite Schicht aus Siliciumnitrid, die sich auf der ersten Schicht aus Siliciumoxid befindet, umfaßt.

5. Struktur unter der Oberfläche in einer integrierten Schaltung, umfassend wenigstens ein p-Kanal-Bauelement und wenigstens ein n-Kanal-Bauelement, die in dem Substrat ausgebildet sind, wobei jedes der Bauelemente eindiffundierte Source- und Drain-Elektroden besitzt, um eine der Source-und Drain-Elektroden des p-Kanal-Bauelementes mit einer der Source- und Drain-Elektroden des n-Kanal-Bauelementes zu verbinden, die einen mit dotierten Polysilicium gefüllten Graben umfassen, der Seitenwände und einen Boden besitzt, die mit einer dünnen dielektrischen Struktur überzogen sind, wobei der Graben zwischen den p-Kanal- und n-Kanal-Bauelementen ausgebildet ist und an eine der Source- und Drain-Elektroden des p-Kanal-Bauelementes und an eine der Source- und Drain-Elektroden des n-Kanal-Bauelementes angrenzt, wobei der Graben sich auf der gleichen topologischen Ebene befindet wie die eindiffundierten Source- und Drain-Elektroden.

## Revendications

1. Structure de sous-surface dans un circuit à semi-conducteur formé dans un substrat ayant un premier type de conductivité, ayant en son sein une zone de puits de potentiel, d'un deuxième type de conductivité, pour interconnecter une première zone de diffusion d'un deuxième type de conductivité, formée dans le substrat, à une deuxième zone de diffusion du premier type de conductivité, formée dans les limites de ladite zone de puits de potentiel, de manière que ladite structure soit située au niveau topologique que lesdites diffusions, comprenant une tranchée ayant des parois latérales et un fond, ladite tranchée étant comblée par un matériau conducteur et ayant une structure diélectrique mince, disposée sur ses dites parois latérales et son fond, de manière que ladite tranchée comblée soit disposée entre, et adjacente à, la première zone de diffusion du deuxième type de conductivité et la deuxième zone de diffusion du premier type de conductivité, ledit matériau conducteur disposé dans ladite tranchée étant relié électriquement à la fois à ladite première et à ladite zone de diffusion.

2. Structure selon la revendication 1, dans laquelle ledit matériau conducteur est choisi dans le groupe composé de polysilicium dopé, de métaux réfractaires, de combinaisons silicées de métal réfractaire et leurs combinaisons.

3. Structure selon la revendication 1 ou 2, dans laquelle ladite structure diélectrique comprend un matériau choisi dans le groupe composé de l'oxyde de silicium, du nitrure de silicium et de l'oxynitrure de silicium.

4. Structure selon l'une quelconque des revendications 1 à 3, dans laquelle ladite structure diélectrique comprend une première couche d'oxyde de silicium formée sur lesdites parois latérales et le fond de ladite tranchée et une deuxième couche de nitrure de silicium située au sommet de ladite première couche d'oxyde de silicium.

5. Structure de sous-surface, dans un circuit intégré comprenant au moins un dispositif à canal p et au moins un dispositif à canal n formé dans un substrat, chacun desdits dispositifs ayant des électrodes de source et de drain diffusées, pour assurer l'interconnexion de l'une des électrodes de source et de drain du dispositif à canal p à l'une des électrodes de source et de drain du dispositif à canal n, comprenant une tranchée, remplie de polysilicium dopé et ayant des parois latérales et un fond, couverte par une structure diélectrique mince, ladite tranchée étant formée entre lesdits dispositifs à canal p et à canal n et étant adjacente à l'une des électrodes de source et de drain du dispositif à canal p et à l'une des électrodes de source et de drain du dispositif à canal n, ladite tranchée étant située au même niveau topologique que les électrodes de source et de drain diffusées.
